(19) **Europäisches Patentamt / European Patent Office / Office européen des brevets**

(11) **EP 3 913 519 A1**

(12) **DEMANDE DE BREVET EUROPEEN**

(43) Date de publication:
**24.11.2021 Bulletin 2021/47**

(51) Int Cl.:
**G06F 30/15** (2020.01)    **G06F 30/27** (2020.01)
**G06F 30/28** (2020.01)

(21) Numéro de dépôt: **21174578.1**

(22) Date de dépôt: **19.05.2021**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **20.05.2020 FR 2005181**

(71) Demandeur: **Bull SAS**
**78340 Les Clayes-sous-Bois (FR)**

(72) Inventeurs:
• GORET, Gaël
  38140 Réaumont (FR)
• NICOLETTI, Léo
  38240 Meylan (FR)
• PRALET, Stéphane
  38880 Autrans (FR)
• BOURRASSET, Cédric
  34700 Lodève (FR)

(74) Mandataire: **Novagraaf Technologies**
**Bâtiment O2**
**2, rue Sarah Bernhardt**
**CS90017**
**92665 Asnières-sur-Seine Cedex (FR)**

(54) **SIMULATION PAR SUBSTITUTION D'UN MODELE PAR LOIS PHYSIQUES PAR UN MODELE A APPRENTISSAGE AUTOMATIQUE**

(57) Procédé de simulation du comportement d'un système (20) composé d'un sous-système (10) dans un environnement physique (21), par un ensemble de modules, chacun simulant une partie dudit système, dans lequel au moins une partie (11) dudit sous-système (10) est simulée par un module mettant en œuvre un réseau de neurones multicouches, les autres modules mettant en œuvre des simulations basées sur des lois physiques comportementales ; ledit procédé comprenant l'évaluation (S2) des résultats de la simulation pour automatiquement décider (S3) d'une stratégie pour déclencher des mises-à-jour (S4) de paramètres associés audit réseau de neurones multicouche.

Fig. 3

**Description**

DOMAINE DE L'INVENTION

La présente invention est relative à la simulation d'un système comportant des sous-systèmes modélisés par des lois physiques. En particulier, elle peut concerner la simulation d'un véhicule, par exemple à des fins de conception du véhicule, afin d'en étudier son comportement.

Plus spécifiquement, l'invention propose un procédé de simulation d'un véhicule, notamment aérien, au sein d'un système, par substitution de la modélisation par lois physiques d'une partie du véhicule simulé par un modèle par apprentissage machine.

CONTEXTE DE L'INVENTION

La conception d'un véhicule, notamment d'un véhicule aérien tel qu'un hélicoptère ou un avion, est un processus complexe engageant de nombreuses personnes pendant plusieurs années et un budget conséquent, qu'il s'agisse d'une conception d'un nouveau véhicule ou d'une nouvelle version d'un véhicule existant.

Les outils numériques, notamment la simulation, permettent de minimiser ces coûts, en permettant de tester différentes configurations de la conception (ou « design ») d'éléments du véhicule en fonction de l'environnement, cet environnement comprenant notamment les autres éléments du véhicule. Ces simulations se basent sur des modèles physiques décrivant le comportement, notamment aérodynamique, des différents éléments du véhicule en fonction de son environnement et des interfaces entre le véhicule et l'environnement.

Les simulations peuvent permettre de déterminer l'impact de chaque choix de conception et d'ainsi explorer un plus grand nombre de possibilités qu'il ne serait envisageable de faire en tests réels. Il est notamment possible de déterminer l'impact de chaque choix pour un élément du véhicule sur l'ensemble du véhicule et, notamment, d'en tirer des conclusions sur le coût global de fabrication, sur la consommation énergétique, sur le bruit généré, etc. Dans l'ingénierie manufacturière, ce processus itératif s'appelle la conception générative (ou « generative design » en langue anglaise).

Toutefois, cette problématique est extrêmement complexe, car un véhicule aérien est, en soi, un système complexe formé de très nombreux éléments différents. En outre, leurs interactions et les interactions avec l'environnement sont nombreuses et difficiles et coûteuses à modéliser de façon précise par des lois physiques. En outre, l'aspect dynamique de l'environnement doit être pris en compte puisqu'un véhicule aérien traverse, au cours d'un vol, différentes phases (montée, vol stationnaire, descente, atterrissage...), chacun impliquant des contraintes physiques (notamment aérodynamique) différentes sur l'appareil.

Malgré la montée en puissance des plateformes de traitement de l'information, un compromis doit traditionnellement être effectué entre la précision des modèles physiques décrivant les comportements de chaque élément du véhicule simulé et le coût informatique de la simulation (coût de la plateforme et temps de traitement).

Ainsi, certains modèles physiques utilisés en dynamique des fluides computationnelle (CFD pour « Computational Fluid Dynamics ») tels que ceux basés sur les équations de Navier-Stokes, demeurent trop coûteuses, en temps de calcul, pour pouvoir être utilisés en simulation industrielle. En outre, l'existence d'une solution n'est pas démontrée et fait même l'objet d'un appel à la communauté mathématique.

Dès lors, des approximations sont en général utilisées. L'utilisation de la décomposition de Reynolds appliquée aux solutions de l'équation de Navier-Stokes permet de simplifier le problème en faisant disparaitre les fluctuations de périodes et d'amplitudes courtes. La méthode est connue sous le nom de moyenne de Reynolds ou sous le terme anglais de RANS pour « Reynolds-averaged Navier-Stokes », ou encore « équation de Navier-Stockes moyennées ». Toutefois, cet allègement des calculs set fait au détriment de la précision.

Ces problématiques liées à la mise en œuvre pratique de la modélisation physiques des éléments constitutifs d'un avion sont par exemple présentées dans l'article de A. Abbas-Bayoumi et K. Becker, « An industrial view on numerical simulation for aircraft aerodynamic design », in Journal of Mathematics in Industry, 1(1):10, 2011. doi: 10.1186/2190-5983-1-10.

Il a été proposé de substituer à certains modèles physiques de la simulation des modèles basés sur l'apprentissage machine.

L'article "A Machine Learning Based Body Force Model for Analysis of Fan-Airframe Aerodynamic Interactions" de Luis López de Vega, Guillaume Dufour, Florian Blanc et William Thollet, in Global Power and Propulsion Society Conférence 2018, 7 May 2018 - 9 May 2018 (Montréal, Canada), propose notamment de substituer un modèle à apprentissage machine (ou « machine-learning model» en langue anglaise) à une partie de la modélisation des turbulences par la méthode de Reynolds. Le modèle en question est un réseau de neurones de type perceptron multicouches. L'article montre par ailleurs des problèmes de précision du modèle neuronal et propose en particulier un procédé pour améliorer sa précision, par apprentissage et en comparant ses performances avec d'autres mécanismes de simulation basé sur la mécanique des fluides computationnelle.

Toutefois, ces travaux visent à substituer un modèle de simulation par un autre, et se focalisent sur les gains et avantages de cette substitution. La plupart n'évoquent pas la substitution d'un (ou plusieurs éventuellement) modules d'un simulateur global par un simulateur basé sur l'apprentissage machine. En outre, aucun ne mentionne les problématiques de couplage, au sein d'un même produit de simulation, de modules basés sur des lois physiques et de modules basés sur l'apprentissage machine.

RESUME DE L'INVENTION

Le but de la présente invention est de fournir une solution palliant au moins partiellement les inconvénients précités. En particulier, l'invention vise à permettre un tel couplage.

L'invention permet également de s'affranchir de la complexité calculatoire de certains modules du simulateur par l'utilisation d'un modèle basé sur l'apprentissage machine. Elle permet ainsi d'éviter le « goulot d'étranglement » formé par certains modules en déportant les aspects calculatoires dans une phase d'apprentissage d'un modèle prédictif qui peut être utilisé lors de la simulation en remplacement du module initial, basé sur les lois physiques.

D'une façon générale et schématique, la présente invention substitue partiellement ou totalement la résolution des équations physiques d'un sous-système par l'inférence d'une intelligence artificielle et propose un procédé de mise au point de cette intelligence artificielle

En particulier, la présente invention propose un procédé de simulation du comportement d'un système composé d'un sous-système dans un environnement physique, par un ensemble de modules, chacun simulant une partie dudit système, dans lequel au moins une partie dudit sous-système est simulée par un module mettant en œuvre un réseau de neurones multicouches, les autres modules mettant en œuvre des simulations basées sur des lois physiques comportementales ; ledit procédé comprenant l'évaluation des résultats de la simulation pour automatiquement décider d'une stratégie pour déclencher des mises-à-jour de paramètres associés audit réseau de neurones multicouche

Suivant des modes de réalisation préférés, l'invention comprend une ou plusieurs des caractéristiques suivantes qui peuvent être utilisées séparément ou en combinaison partielle entre elles ou en combinaison totale entre elles :

- lesdites mises à jour comprennent une ou plusieurs actions parmi :

    a) une augmentation d'un ensemble d'apprentissage par interpolation des données dudit ensemble et un réentrainement dudit réseau de neurones multicouche sur ledit ensemble d'apprentissage ;

    b) une modification des paramètres physiques du modèle physique de génération de l'ensemble d'apprentissage et un réentrainement dudit réseau de neurones multicouche sur ledit ensemble d'apprentissage ;

    c) une modification des méta-paramètres dudit réseau de neurones ;

- lesdits méta-paramètres comprennent ceux déterminant l'architecture du réseau de neurones ;

- ledit sous-système est un véhicule aérien ;

- ladite partie est un turboréacteur ;

- la décision d'une stratégie est basée sur un coût temporel associé à chacune desdites actions ;

- la décision d'une stratégie est basée sur un historique des actions déjà déclenchées.

- lorsque l'évaluation fait ressortir un manque local de précision de ladite simulation, ladite augmentation d'un ensemble d'apprentissage par interpolation des données dudit ensemble et un réentrainement dudit réseau de neurones multicouche sur ledit ensemble d'apprentissage, est prioritairement déclenchée.

Un autre aspect de l'invention concerne un procédé de conception d'un véhicule aérien comportant le procédé de simulation précédemment décrit.

Un autre aspect de l'invention concerne un dispositif de simulation pour la mise en œuvre d'un procédé tel que précédemment décrit.

Ainsi, un avantage est de réaliser un couplage entre les modules basés sur les lois physiques et les modules basés sur l'apprentissage machine. En particulier, selon des modes de réalisation, les résultats de la simulation globale peuvent être utilisés pour déterminer, au fil de l'eau, des méta-paramètres du (ou des) modules basés sur l'apprentissage machine.

Un autre avantage est que l'approche proposée n'est pas intrusive, c'est-à-dire que les autres modules mettant en œuvre la simulation ne sont pas impactés par la substitution. Il est ainsi possible de connecter le module modifié dans un produit de simulation existant en tirant profit des interfaces existantes et donc à moindre surcoût de développement.

Des mises en œuvre de l'invention permettent ainsi la simulation d'un système composé d'un sous-système tel qu'un véhicule aérien, au sein d'un environnement physique, par exemple pour la conception d'un tel véhicule aérien. L'efficience de l'invention permet d'accroitre la qualité de la simulation tout en conservant des temps de simulation compatibles avec les requis industriels. Ainsi, la conception de dispositifs tels que des véhicules aériens s'en trouve facilitée.

D'autres caractéristiques et avantages de l'invention apparaîtront à la lecture de la description qui suit d'un mode de réalisation préféré de l'invention, donnée à titre d'exemple et en référence aux dessins annexés.

BREVE DESCRIPTION DES DESSINS

La [Fig. 1] représente schématiquement un exemple de système composé d'un véhicule aérien et de son environnement selon une mise en œuvre de l'invention.

La [Fig. 2] illustre de façon schématique un réseau de neurones multicouche tel que pouvant être utilisé dans le cadre d'une mise en œuvre de l'invention.

La [Fig. 3] représente schématiquement un exemple d'organigramme selon une mise en œuvre de l'invention.

La [Fig. 4] représente schématiquement un exemple d'organigramme, plus détaillé, selon une mise en œuvre de l'invention

La [Fig. 5] illustre un exemple de simulateur comportant un ensemble de modules, selon un mode de réalisation de l'invention.

DESCRIPTION DETAILLEE DE L'INVENTION

L'invention est susceptible de s'appliquer à toute simulation d'un système complexe modélisé par des lois physiques comportementales, typiquement des lois de la dynamique des fluides. Elle peut ainsi concerner la simulation de systèmes météorologiques, par exemple, ou bien le comportement d'un sous-système vis-à-vis d'un milieu fluide au sein d'un système, ce sous-système pouvant notamment être un véhicule.

L'invention peut notamment s'appliquer à la situation où une partie d'un sous-système à simuler peut correspondre à une modélisation physique distincte de celle des autres parties du sous-système. Par exemple, elle peut s'appliquer à la situation d'un sous-système dont une partie correspond à une topologie ou une dynamique particulière, par exemple des pales en mouvement.

L'invention peut ainsi s'appliquer à un sous-système tel qu'une éolienne dans le milieu fluide de l'air, ou d'autres dispositifs fonctionnant de manière similaire, c'est-à-dire avec des pales plongées dans un flux de fluide : compresseurs radiaux et axiaux dans les turboréacteurs d'avion, dans les dispositifs de climatisation, dans les gazoducs, dans les turbocompresseurs, etc.

L'invention peut également s'appliquer à différents types de véhicules pour lesquels se posent des problématiques liés à la pluralité des éléments à simuler et à la complexité d'au moins certains d'entre eux à être simulé par des lois physiques.

Elle s'applique notamment aux véhicules aériens pour lesquels la simulation par les lois physiques de l'aérodynamique engendre des difficultés de mise en œuvre, notamment en termes de précisions et de coût informatique. Ces véhicules aériens peuvent notamment être des hélicoptères, des avions, etc.

Pour un tel sous-système, selon un mode de réalisation de l'invention, une partie du véhicule correspondant aux turboréacteurs dans lesquels des pales sont en mouvement, peut correspondre à une modélisation physique distincte du reste du sous-système.

L'invention peut également s'appliquer à d'autres types de véhicules, notamment marins ou sous-marins, pour lesquels les lois physiques de l'hydrodynamique posent des problématiques similaires.

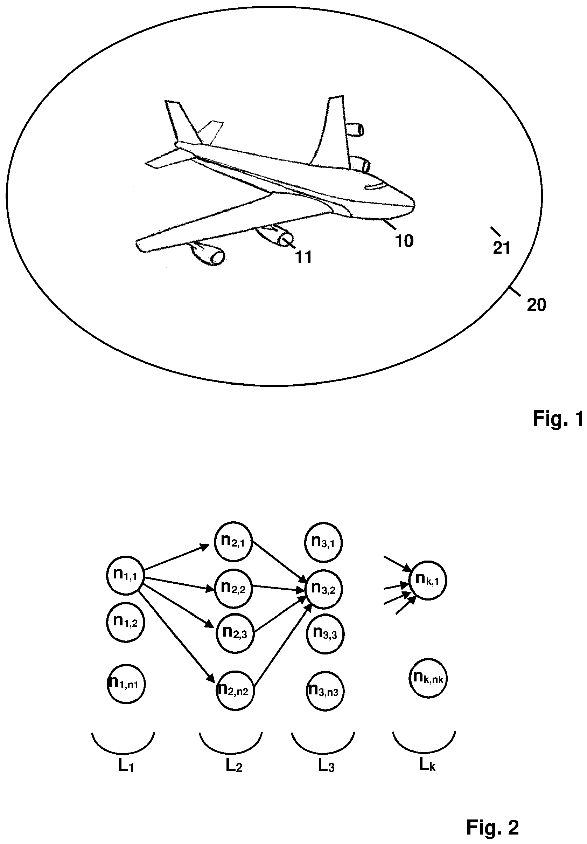

La figure 1 illustre un exemple d'application à un véhicule aérien tel qu'un avion, sans perte de généralité.

Le procédé et le dispositif selon l'invention visent à simuler le comportement d'un système 20 composé du véhicule aérien 10 dans son environnement physique 21 ambiant. En effet, afin de simuler le comportement du véhicule aérien 10, il est nécessaire de simuler également les interactions entre celui-ci et son environnement et notamment l'influence de l'avion sur son environnement.

Un tel système peut être simulé par des outils logiciels mettant en œuvre des techniques de mécanique des fluides numérique, CFD (pour « *Computational Fluid Dynamics* » en langue anglaise) afin de déterminer les interactions entre le véhicule 10, ou certaines parties 11 du véhicule, telles qu'une tuyère d'un turboréacteur, et l'environnement physique 21 dans lequel il circule.

On peut par exemple citer les logiciels commercialisés par la société Dassault Systèmes, tels que le produit logiciel « Simulia ». On peut également citer le logiciel « Flow Simulator » de la société HyperWorks, avec différents modules de simulation physique (« elsA » produit par l'ONERA, « Su2 » de l'université de Stanford, etc.).

La mécanique des fluides numérique, CFD, consiste à étudier les mouvements d'un fluide (ici l'air) et leurs effets par la résolution numérique des équations régissant le fluide. En fonction des approximations choisies, qui sont en général le résultat d'un compromis en termes de besoins de représentation physique par rapport aux ressources de calcul ou de modélisation disponibles, les équations résolues peuvent être les équations d'Euler, les équations de Navier-Stokes, etc.

De manière générale, la résolution d'un problème de mécanique des fluides numérique passe par

- la préparation du problème : ceci passe par la définition d'une géométrie, d'un maillage discrétisant le domaine de calcul, du choix des modèles et méthodes numériques employés ;

- la résolution numérique du problème qui passe par l'exécution d'un programme informatique mettant en œuvre une modélisation mathématique du comportement du système 20.

D'autres aspects du comportement du système 20 peuvent également être pris en charge tels que par exemple les aspects thermiques.

D'une façon générale, cette technique basée sur la mécanique des fluides vise à fournir un modèle basé sur des lois physiques comportementales, c'est-à-dire à approximer le comportement du système par des lois, ou équations, physiques. En appliquant ces lois, ou équations, on peut estimer le comportement du système.

Le maillage consiste à découper l'espace en cellules appelées « volumes de contrôle ». Le maillage est souvent délicat en mécanique des fluides car il faut mailler tout l'espace du système 20, y compris l'espace « vide » formé par l'environnement physique 21. Il en résulte donc un grand volume de maillage.

En outre, les détails de surface ont de l'importance puisqu'ils peuvent générer des turbulences. Il en résulte la nécessité d'un maillage très fin, notamment aux abords des surfaces (c'est-à-dire à l'interface entre l'avion 10 et l'environnement physique 21).

Dès lors, on a donc souvent des maillages contenant de très nombreuses mailles (typiquement plusieurs millions).

Par ailleurs, alors qu'en résistance des matériaux, un maillage hexaédrique de l'espace est une stratégie intéressante (elle permet d'avoir la même qualité de résultats pour un nombre de nœuds plus faibles), en mécanique des fluides numérique, cela introduit des directions préférentielles qui peuvent avoir une influence sur le résultat.

Aussi, d'autres types de maillage sont possibles, comme par le maillage hexaédrique, et des maillages non-uniformes, permettant des résolutions différentes ou des typologies ou orientations différentes, selon les zones. Par exemple, il est possible d'avoir

- à proximité des surfaces (interfaces avion/environnement), un maillage parallèle à la surface - hexaédrique ou bien prismatique (hexaèdres coupés en deux) - et de faible épaisseur (trois couches de cellules par exemple) ;

- au cœur des volumes, un maillage tétraédrique mais n'ayant pas de direction particulière, et par exemple, de moindre résolution.

Certains systèmes 20 à simuler peuvent être extrêmement complexes et mettre en jeu des phénomènes physiques divers. C'est notamment le cas d'un véhicule aérien comme un avion qui engendre des problématiques physiques différentes : portance des ailes, turbulence aux niveaux de l'admission (soufflante) et de la sortie (tuyères) des turboréacteurs, etc.

Dès lors, le système peut être décomposé en une pluralité de modèles physiques, certains de ces modèles pouvant être dédiés ou adaptés à une partie du système 20.

Par exemple, les phénomènes de turbulences en admission ou en sortie des turboréacteurs ont fait l'objet d'études spécifiques sur les phénomènes aérodynamiques en jeu.

Une approche assez utilisée est le modèle des forces corporelles (ou « *body force model* », BFM, en langue anglaise) qui vise à remplacer les pales du turboréacteur par des champs de force équivalent.

Ce modèle a été proposé par Marble, F. E, 1964, "Three-Dimensional Flow in Turbomachine" in High Speed Aerodynamics and Jet Propulsion, Vol. 10, Sec. C, Princeton University Press, pp. 83-166. Il a été largement appliqué depuis, ainsi que par exemple indiqué dans Hsiao, E., Naimi, M., Lewis, J.P., Dalbey, K., Gong, Y. et Tan, C., "Actuator Duct Model for Turbomachinery Components for Powered-Nacelle Navier-Stokes Calculations," Journal of Propulsion and Power, vol. 17, no. 4, July-August 2001, ou encore Thollet, William et Dufour, Guillaume et Carbonneau, Xavier et Blanc, Florian "Body-force modeling for aerodynamic analysis of air intake - fan interactions" in (2016) International Journal of Numerical Methods for Heat & Fluid Flow, vol. 26 (n° 7). pp. 2048-2065. ISSN 0961-5539

Un des avantages de ce modèle est son intégration dans les simulateurs de mécanique des fluides numérique, notamment dans les équations de Navier-Strokes calculées par moyenne de Reynolds (modèle RANS).

Aussi, les simulateurs agrègent des modules, chacun simulant une partie du système 20 et pouvant mettre en œuvre un modèle différents Ces modules peuvent être des parties du code informatique d'une même entité logicielle, mais il peut également s'agir d'entités logicielles autonomes interagissant au moyen d'interfaces préalablement définies. On comprend que ces aspects sont liés à l'implémentation architecturales logicielles. L'invention exposée ci-dessous est indépendante de ces choix architecturaux, qui relèvent du développeur et/ou du choix d'outil de simulation utilisé.

Les modèles de chaque module peuvent être différents par nature (technologie différente, équations de modélisation différentes) ou simplement par des valeurs différentes données à certains paramètres pour des mêmes modélisations mathématiques.

Par technologie différente, on entend notamment un modèle basé sur des lois physiques comportementales et un modèle basé sur de l'apprentissage machine. En particulier, ce modèle basé sur l'apprentissage machine peut être un réseau de neurones multicouches.

Selon l'invention, au moins une partie du véhicule aérien 10 est simulée par un module mettant en œuvre un réseau de neurones multicouches, les autres modules mettant en œuvre des simulations basées sur des lois physiques comportementales. Autrement dit, un modèle basé sur un réseau de neurones multicouches est substitué à au moins un des modèles basé sur les lois physiques comportementales selon la mécanique des fluides (CFD).

Selon un mode de réalisation de l'invention, un tel réseau de neurones multicouches peut modéliser le comportement d'une entrée (soufflante) et/ou d'une sortie (tuyère) d'un turboréacteur, 11, de l'avion 10, notamment les turbulences créées par de tels dispositifs en interaction avec l'environnement 21.

D'une façon très macroscopique, les réseaux de neurones multicouches peuvent être vus comme des boîtes noires dont les paramètres internes doivent être ajustés lors d'une phase d'apprentissage, ou d'entrainement, en leur présentant à la fois des données d'entrée et une sortie souhaitée (ou « étiquette »). L'erreur entre cette sortie souhaitée et la sortie « naturelle » du réseau permet d'ajuster légèrement les paramètres pour diminuer l'erreur. En présentant un grand nombre de ces couples « données d'entrée / sortie souhaitée », le réseau apprend à réagir correctement et à fournir une bonne sortie lorsqu'on lui présente de nouvelles données d'entrée, non étiquetées.

Selon un mode de réalisation de l'invention, le réseau de neurones utilisé peut être un perceptron multicouche. D'autres architectures de réseaux neuronaux peuvent être possibles. Notamment, un réseau de neurones convolutif peut être utilisé (ConvNet ou CNN pour « *Convolutional Neural Network* » en anglais).

Le perceptron multicouches (ou « *multilayer perceptron* », MLP, en anglais) est un type de réseau neuronal artificiel organisé en plusieurs couches au sein desquelles une information circule de la couche d'entrée $L_1$ vers la couche de sortie $L_k$ uniquement ; il s'agit donc d'un réseau à propagation directe (« *feedforward* »). Chaque couche $L_1$, $L_2$, $L_3$... $L_k$ est constituée d'un nombre variable de neurones, respectivement $n_1$, $n_2$, n... $n_k$. Les neurones de la dernière couche (dite « de sortie ») sont les sorties du réseau de neurones et représentative d'une prédiction du modèle en réponse à une entrée fournie sur la couche $L_1$.

Dans un perceptron multicouches, chaque neurone $n_{i,j}$ est connecté en sortie à la totalité des neurones de la couche suivante $L_{i+1}$. Inversement, il reçoit en entrée les sorties de la totalité des neurones de la couche précédente $L_{i-1}$. Sur la figure 2, par clarté, seules quelques connexions sont représentées par des flèches orientées.

Chaque connexion est associée à un poids. L'ensemble des poids forment les paramètres internes du réseau de neurones. Ils doivent être déterminés lors d'une phase d'apprentissage (ou entrainement) et permettent ensuite de prédire des valeurs de sortie, par généralisation, à partir d'un nouveau vecteur d'entrée présenté sur la couche d'entrée $L_1$.

Chaque neurone $n_{i,j}$ effectue, classiquement, une somme pondérée de ces entrées par les poids des connexions associées puis applique à cette somme une fonction d'activation.

Plusieurs techniques existent pour déterminer les paramètres internes du réseau, les seuils, par apprentissage. On peut notamment citer l'algorithme de la descente du gradient stochastique (DGS ou SGD en anglais pour « *Stochastic Gradient Descent* »), décrit par exemple dans LeCun, Yann A., et al. "Efficient backprop. Neural networks: Tricks of the trade", Springer Berlin Heidelberg, 2012. 9-48. On peut également citer ADAM, décrit initialement dans Diederik P. Kingma and Jimmy Lei Ba. "Adam: A method for stochastic optimization". 2014. arXiv:1412.6980v9, ou bien RMSprop, décrit notamment dans Tijmen Tieleman et Geoffrey Hinton, « Lecture 6.5-rmsprop: Divide the gradient by a running average of its recent magnitude », COURSERA: neural networks for machine learning, 4(2):26-31, 2012.

Un des aspects de l'invention consiste à permettre l'apprentissage et la détermination de l'ensemble des paramètres du réseau de neurones multicouche. En particulier, la simulation globale du système 20, englobant des modèles basés sur les lois physiques comportementales et un ou plusieurs modèles basés sur des réseaux neurones, peut être évaluée afin de permettre l'ajustement de certains paramètres du réseau de neurones. On obtient ainsi un couplage entre le modèle par réseau de neurone, substitué au modèle par lois physiques, et les modèles par lois physiques non-substitués.

Les paramètres du réseau de neurones comprennent notamment :

- les paramètres internes, ou poids, associés aux connexions entre neurones, et étant déterminés de façon itérative par l'apprentissage (ou entrainement) ;

- des méta-paramètres déterminant l'architecture du réseau de neurones : nombres de couches, nombres de neurones dans chaque couche, etc.

- les données de l'ensemble d'apprentissage, qui permettent la détermination des poids ;

- la fonction de coût qui permet d'estimer l'erreur en sortie du réseau de neurones et déterminer, par rétropropagation, les ajustements à apporter aux poids du réseau pour chaque donnée de l'ensemble d'apprentissage ;

- les noyaux de convolution, dans le cas d'un mode de réalisation basé sur des réseaux neuronaux convolutifs.

D'une façon générale, ces paramètres sont relatifs soit aux poids du réseau de neurones (paramètres internes) ou aux méta-paramètres du réseau de neurones (y compris la fonction de coût), soit à l'ensemble d'apprentissage sur lequel le réseau de neurones est entrainé

Selon un mode de réalisation de l'invention, une adaptation du maillage de l'ensemble d'apprentissage basé sur l'erreur résiduelle (« *Residual error based adaptive mesh refinement* », en anglais). Ce mécanisme permet d'échantillonner, durant l'entrainement, de manière plus dense, les zones qui sont moins bien prédites par le modèle (c'est-à-dire qui présent une valeur de la fonction de résidu plus élevée). Cela permet d'augmenter automatiquement la densité des données dans les zones les plus difficiles à prédire (perturbations, zones de surface...)

Ce réseau de neurones multicouche est entrainé au moyen de données d'entrainement issues soit du monde physique, soit d'une modélisation du monde physique, c'est-à-dire d'un modèle basé sur des lois physiques comportementales telles que précédemment décrites.

Au moins deux façons de faire existent :

- il est ainsi possible d'entrainer le réseau de neurones sur la base d'un ensemble d'apprentissage généré par un modèle physique comportemental ;

- il est également possible de contraindre le mécanisme d'apprentissage lui-même par la modélisation physique, notamment en agissant sur la fonction de coût.

Un réseau de neurones entrainé selon cette seconde approche est parfois appelé, en anglais, « *Physics-Informed Neural Network* » (PINN). Il a été par exemple décrit dans l'article *"Physics-Informed Neural Networks: A Deep Learning Framework for Solving Forward and Inverse Problems Involving Nonlinear Partial Differential Equations"* de Raissi, Maziar, Perdikaris, Paris, and Karniadakis, George E, in Journal of Computational Physics, 2019

Les lois physiques comportementales peuvent prendre la forme d'un système d'équations aux dérivées partielles de la forme

[Math. 1]

$$\partial_t u + \mathcal{N}[u; \lambda] = 0$$

dans laquelle

$$\mathcal{N}[]$$

est un opérateur non-linéaire sur la fonction u avec pour paramètre $\lambda$.

Un tel formalisme permet d'exprimer un grand nombre de problématique se posant en physique comportementale : lois de conservation de l'énergie, processus de diffusion, systèmes d'advection-diffusion-réaction, équations cinétiques, etc.

On appelle f(x,t) le résidu de l'équation aux dérivées partielles au point (x, t) et on cherche à approximer la fonction u par un réseau de neurones multicouches. On obtient le système :

[Math. 2]

$$\begin{cases} u(x,t) \cong NN(x,t) \\ f := \partial_t u + \mathcal{N}[u;\lambda] \end{cases}$$

où « NN(x,t) » représente la sortie du réseau de neurones, c'est-à-dire le vecteur des sorties de chaque neurone de la couche de sortie.

Dans cadre de l'utilisation de ce système à des fins de prédiction, le problème revient à rechercher l'état caché u(x ,t)

Le réseau de neurones vise à itérativement approximer la fonction u tout en minimisant une fonction de coût c prenant en compte à la fois un coût $c_u$ exprimant la capacité de prédiction du réseau de neurones, et un coût $c_f$ exprimant les contraintes liés à la modélisation physique. Typiquement $c = c_u + c_f$.

On peut exprimer ces coûts comme des erreurs de moindres carrés. Le coût c peut alors s'exprimer :

[Math. 3]

$$c = c_u + c_f \quad avec \quad \begin{cases} c_u = \dfrac{1}{N_u} \sum_{i=1}^{N_u} |u(t_u^i, x_u^i) - u^i|^2 \\ c_f = \dfrac{1}{N_f} \sum_{i=1}^{N_f} |f(t_f^i, x_f^i)|^2 \end{cases}$$

Le terme $c_f$ pénalise les solutions issues du réseau de neurones qui ne satisfont pas (ou pas suffisamment) les contraintes physiques exprimées par la fonction f.

Selon un mode de réalisation de l'invention, un modèle basé sur les forces corporelles (ou « *body force model* », BFM, en langue anglaise) peut être remplacé. Ce modèle est particulièrement intéressant pour simuler des dispositifs de géométrie complexe et dynamique, telles que des turboréacteurs. Ce modèle permet notamment de prendre en compte la dynamique des pales en mouvement, afin de les intégrer dans les équations RANS ainsi que précédemment expliqué.

Une telle modélisation est notamment décrite dans "Body Force Modeling of the Aerodynamics of a Low-Speed Fan under Distorted Inflow" d'Emmanuel Benichou, Guillaume Dufour, Yannick Bousquet, Nicolas Binder, Aurélie Ortolan et Xavier Carbonneau in Int. J. Turbomach. Propuls. Power, 2019, 4(3), 29

L'équation décrivant l'apprentissage devient alors:

[Math. 4]

$$\begin{cases} \dfrac{f_n h}{W^2} \cong NN_{f_n}\left(\dfrac{x}{r_{tip}}, \dfrac{x}{r_{tip}}, M_r, \beta, \dfrac{C_p T}{U_{tip}^2}\right) \\ \dfrac{f_p h}{W^2} \cong NN_{f_p}\left(\dfrac{x}{r_{tip}}, \dfrac{x}{r_{tip}}, M_r, \beta, M_r^{LE}, M_r^{tE}, \beta_r^{LE}, \beta_r^{tE}\right) \end{cases}$$

avec :

- $f_n$ la composante normale de la force corporelle f (ou *"body force"*)
- $f_p$ la composante parallèle de la force corporelle f ;
- h le pas local des pales du turboréacteur ;
- W la vélocité relative
- x la coordonnée axiale,
- $r_{tip}$ la coordonnée radial de la pointe du rotor;
- $M_r$ le nombre de Mach relatif qui qualifie la compressibilité du fluide;
- $\beta$ l'angle azimutal relatif du flux ;
- $C_p$ la capacité calorifique ;
- T la température statique ;
- $U_{tip}$ la vitesse de la pointe du rotor ;
- Et « LE » et « TE », en exposant, indique que la valeur est mesurée, respectivement, en tête (« *leading edge* », LE) ou en queue (« *trailing edge* », TE) des pales.

On peut écrire la fonction de coût :

[Math. 5]

$$J(\omega) = \frac{1}{N}\sum_{i=1}^{N}\left(\tilde{f}_i^{\omega} - f^i\right)^2 + \frac{1}{N}\lambda\sum_{i=1}^{M}\omega_j^2$$

avec:

- $\omega$ les poids du réseau de neurones ;
- N le nombre d'échantillon dans l'ensemble d'apprentissage ;
- M le nombre de poids dans le réseau de neurones ;
- et $\lambda$ un paramètre de régularisation.

Le réseau de neurones multicouches peut donc prendre en vecteur d'entrée un ensemble de variables qui, typiquement, caractérisent l'écoulement de flux dans le turboréacteur modélisé ainsi qu'indiqué ci-dessus.

En sortie, ce réseau de neurones multicouches peut notamment prédire des variables qui caractérisent les composantes normale $f_n$ et parallèle $f_p$ de la force corporelle f (ou « body force »).

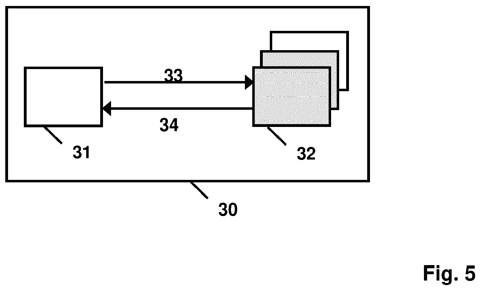

La figure 5 illustre un exemple de simulateur 30 comportant un ensemble de modules, 31, 32. Le module 31 met en œuvre un réseau de neurones multicouches permettant de prédire les forces corporelles f d'une partie d'un sous-système d'un système simulé, par exemple un turboréacteur, à partir des données 34 fournies par les autres modules 32 du simulateur 30. Les prédictions du réseau de neurones 31 sont transmises, 33, à ces autres modules 32, de sorte à former une boucle itérative.

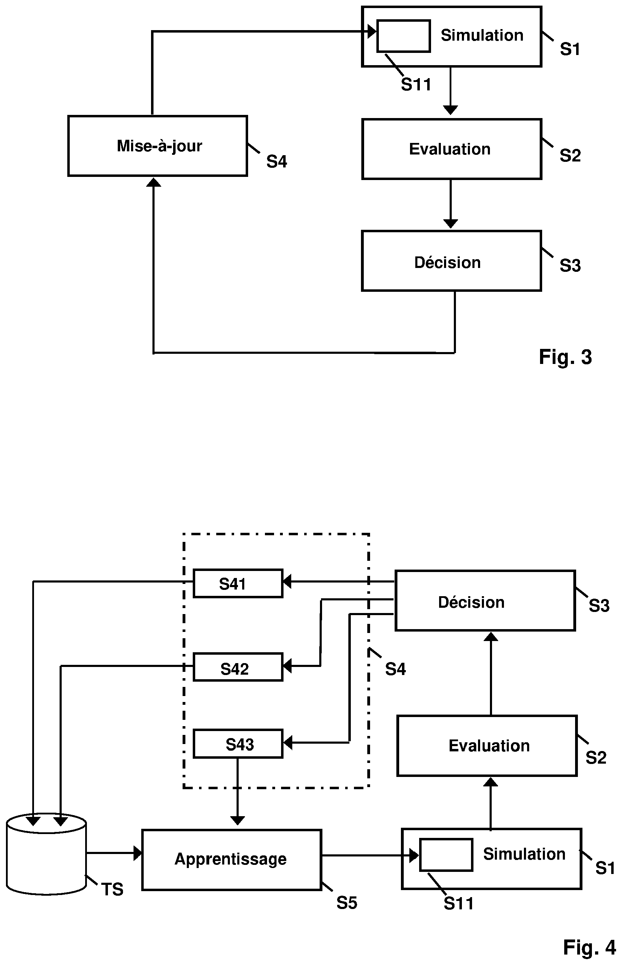

La figure 3 illustre les différentes étapes du procédé selon un mode de réalisation de l'invention.

Dans une étape S1, le logiciel de simulation effectue une simulation du système 20, en incluant une sous-étape S11, dans laquelle au moins une partie du véhicule aérien 10 est simulée par un module mettant en œuvre un réseau de neurones multicouches. Comme il sera vu ultérieurement, ce réseau de neurones multicouches est entrainé dans une étape S5.

Dans une étape S2, les résultats de cette simulation peuvent être évalués.

Il est à noter que cette évaluation, en étape S2, est de nature différente de celle effectuée lors de l'entrainement du réseau de neurones, en étape S5, au moyen d'une fonction de coût (« *loss fonction* ») appliquée en sortie du réseau.

En effet, l'évaluation de l'étape S5 vise à l'optimisation de la simulation dans sa globalité, c'est-à-dire de l'étape S1 qui inclut la sous-étape S11 mais ne s'y résume pas. Notamment, donc, cette étape d'évaluation permet l'optimisation du couplage entre le réseau de neurones multicouches et les autres modules du simulateur, basés notamment sur la mécanique des fluides computationnelles.

Cette évaluation, S2, peut permettre de déclencher des actions correctives, en étape S4, pouvant toucher à l'ensemble du processus de simulation, comme il sera vu plus loin.

Cette évaluation S2 peut se baser sur des mesures objectives de la qualité de l'inférence dans le contexte du couplage du réseau de neurones multicouche avec les autres modules de la simulation.

Notamment, l'évaluation comprend l'estimation de la précision de la simulation, à la fois de façon globale et locale. En particulier, l'évaluation peut permettre de déterminer des zones dans le système 20 simulé, dans lesquelles la précision est insuffisante.

Pour ce faire une fonction objective peut être fournie, permettant de faire ressortir ces problèmes de précision du résultat d'une simulation, en fonction d'un résultat escompté.

Cette fonction objective peut être conçue pour représenter les connaissances métiers permettant d'une part de mesure une qualité de la simulation effectuée, cette mesure devant être itérativement maximisée, et d'autre part de détecter les causes impactant cette mesure de qualité.

Elle permet donc de détecter automatiquement des types d'erreur du simulateur et d'ainsi pouvoir proposer (en étape S3) le correctif le plus adéquat, afin d'améliorer, aux itérations suivantes, la simulation incluant (ou « augmentée par ») le réseau de neurones multicouches.

D'une façon générale, l'évaluation peut être fournie par le logiciel de simulation automatiquement. Elle peut ressortir d'une mesure de l'énergie dans un logiciel basé sur la mécanique des fluides computationnelle.

Les résultats issus de la simulation doivent contenir suffisamment d'information pour permettre d'orienter la recherche paramétrique. Après une phase d'initialisation on peut exploiter l'ensemble des associations entre hyper paramètres et valeur de la fonction objective (ou de coût). Cette phase d'initialisation peut être aléatoire, ou via d'autres heuristiques comme par exemple les hypercubes latins (ou LHD pour « *Latin Hypercube Sampling* » en anglais)

Ces associations permettent de régresser l'espace d'optimisation dans lesquels on se déplace pour évaluer un nouveau point (définissant une nouvelle itération avec un nouvel ensemble de paramètres), ce qui apporte au fil de l'eau de plus en plus de connaissances concernant la relation liant paramètres et performance de la simulation.

L'évaluation peut également être fournie (partiellement ou totalement) de façon manuelle par un ingénieur qui analyse les résultats de la simulation.

Cette évaluation est « en ligne » (ou « *online* » en anglais), c'est-à-dire qu'elle est effectuée au fil de l'eau lors d'une nouvelle simulation du système. Autrement dit, la simulation forme une boucle de réaction qui peut déclencher une réapprentissage du réseau de neurones multicouches. Contrairement à certaines solutions habituelles, donc, il n'y a pas de nette séparation entre une phase d'apprentissage et une phase d'exploitation (ou prédiction) du réseau de neurones, les deux phases étant entrelacées.

Selon un mode de réalisation, un échantillonnage peut être effectué afin de n'effectuer une évaluation que sur un échantillon (par exemple périodique) des simulations effectuées.

Ainsi, chaque simulation est susceptible de déclencher une adaptation du modèle par réseau de neurones, de sorte à minimiser son erreur de prédiction dans le cadre global de la simulation du système 20 et, donc, d'améliorer la précision des simulations subséquentes.

En fonction de cette évaluation de la simulation, une étape de décision S3 consiste à automatiquement décider d'une stratégie pour déclencher des mises à jour, dans une étape S4, des paramètres associés au réseau de neurones multicouche. Le but recherché est d'itérativement optimiser l'évaluation de la simulation, en minimisant les problèmes remontés (notamment de manque de précision global ou local).

En particulier, donc, les problèmes détectés dans l'étape d'évaluation S2 permettent de guider une stratégie pour optimiser le modèle neuronal afin que, dans les simulations subséquentes, sa prédiction soit davantage conforme au monde réel, et qu'ainsi les simulations aient une meilleure précision.

L'étape de décision S3 peut mettre en œuvre des heuristiques permettant de déterminer une stratégie en fonction du résultat de l'étape d'évaluation S2.

Cette heuristique peut être mise en œuvre de différentes façons. Elle peut notamment correspondre à un ensemble de règles informatiques. Ces règles informatiques peuvent être le reflet de règles métiers qui permettent d'envisager les différentes situations pouvant se présenter.

À titre d'exemples illustratifs, on peut identifier différents types de fonctions objectives qui nous renseignent sur l'état du couplage entre le réseau de neurones multicouches et les autres modules du simulateur.

- Retour d'erreurs de l'outil de simulation : par exemple, présence de valeurs aberrantes du point de vue physique, de situation de « Nan » (« *not a number* »)
  On peut également récupérer des informations sur la localisation spatiale du manque de précision, limite d'application des méthodes numériques

- Fonction de cout basée sur les résidus de quantité physiques. Ces résidus sont disponibles en sortie des modules du simulateur (et sont appliqués en entrée du réseau de neurones multicouches).
  Cette fonction peut être basée sur l'Energie du système simulé (Energie cinétique, Hamiltonien...). On peut aussi évaluer si le réseau de neurones est employé loin de sa zone d'entrainement (spectre des entrées), ou s'il est adapté aux entrées rencontrées dans la simulation.

- Contrôle de la quantité issue d'un modèle d'amortissement de l'énergie dans les dynamiques (selon la théorie de Kolmogorov). Ce contrôle peut être effectuée de façon asynchrone.

La figure 4 illustre une mise en œuvre plus précise des mécanismes de décisions et de mises à jour des paramètres associés au modèle à réseau de neurones.

Notamment, l'étape de décision S3 peut déclencher différentes actions de mise à jour, S41, S42, S43, qui peuvent agir soit sur le mécanisme d'apprentissage S5 (méta paramètres...), soit sur la base d'apprentissage TS sur laquelle est entraîné le réseau de neurones, lors de l'étape d'apprentissage S5.

Il apparaît ainsi une boucle de rétroaction selon laquelle la simulation S1, comprenant la simulation par réseau de neurones S11, est évaluée, S2, afin de déterminer, S3, une stratégie de mise à jour, S41, S42, S43 des paramètres de réseau de neurones. Le réseau de neurones peut être réentraîné, sur la base de ces paramètres, afin d'améliorer les performances prédictives du réseau de neurones à la prochaine simulation S1.

L'entrainement du réseau de neurones peut être effectué au fil de l'eau, c'est-à-dire chaque fois que de nouveaux paramètres sont déterminés, ou bien de façon périodique.

Une mise à jour possible peut consister à, étape S41, effectuer une augmentation (ou enrichissement) de l'ensemble d'apprentissage TS par interpolation. Cette augmentation peut être locale.

Par exemple, si l'évaluation S2 de la simulation fait ressortir un manque de précision sur une zone du système 20 simulé, le mécanisme de décision S3 peut appliquer une stratégie consistant à déclencher un rééchantillonnage des données de l'ensemble d'apprentissage TS sur cette zone, afin d'entrainer de façon plus efficace le réseau de neurones et lui conférer de meilleures performances de prédiction sur cette zone.

Une autre mise à jour possible peut consister à, étape S42, modifier les paramètres physiques du modèle physique de génération de l'ensemble d'apprentissage TS.

Ce modèle physique vise à simuler le comportement de la partie du système 20 simulé par le réseau de neurones, mais par des lois physiques comportementales. Autrement dit, ce modèle correspond à celui substitué par le réseau de neurones dans le cadre de la simulation, S1, mais son usage est ici de générer les données de l'ensemble d'apprentissage TS servant à l'entrainement du réseau de neurones.

Typiquement, ce modèle physique génère des données d'apprentissage, associant des données d'entrées, formées par les conditions aux interfaces de la partie de l'avion simulée (température, vecteur d'air, etc. à chaque point du maillage), à des étiquettes qui représentent les résultats de la simulation physique et la sortie souhaités pour le réseau de neurones.

Comme il a été évoqué plus haut, la simulation par lois physiques comportementale (notamment basée sur la mécanique des fluides numérique, CFD), fait, en simulation, l'objet d'un compromis entre la précision et le temps de calcul nécessaire. Dans la mesure où ce modèle physique est utilisé dans le cadre de la génération de l'ensemble d'apprentissage TS, les contraintes temporelles sont moindres, puisque l'apprentissage peut être décorrélé du flux de simulation S1. Autrement dit, on tire ainsi profit du coût computationnel relativement constant de l'inférence par réseau de neurones, ce coût étant déporté vers la phase d'apprentissage.

Dès lors, le compromis peut être très différent et favoriser la précision au détriment du temps de calcul, qui est ici moins impactant pour les performances computationnelles de la simulation. Les paramètres de ce modèle physique peuvent notamment comprendre le maillage du système 20, ainsi que précédemment décrit.

Ainsi, si l'évaluation S2 de la simulation fait ressortir un manque de précision sur une zone du système 20 simulé, le mécanisme de décision S3 peut appliquer une règle de stratégie consistant à déclencher une modification des paramètres du modèle physique de génération de l'ensemble d'apprentissage TS, notamment le maillage du système 20.

Une autre mise à jour possible peut consister à, étape S43, modifier les méta-paramètres du réseau de neurones. Ces méta-paramètres comprennent notamment ceux déterminant l'architecture du réseau de neurones : nombre de couches cachés, nombres de neurones pour chaque couche, fonction d'activation (softmax, ReLu...), etc.

Par exemple, si la surveillance de la quantité issue d'un modèle d'amortissement de l'énergie fait ressortir un problème de convergence, certains méta-paramètres du réseau de neurones peuvent être modifiés, par exemple dans l'optique d'en élargir la capacité (augmentation du nombre de couches et/ou de neurones par couches).

L'étape de décision S3 automatique d'une stratégie pour déclencher les mises à jour, S41, S42, S43 met en œuvre une heuristique permettant de choisir la ou les meilleures actions de mise à jour selon des critères prédéfinis.

Cette heuristique peut notamment se baser sur :

- La caractérisation « locale ou globale » des problèmes de précision, remontés dans l'évaluation de la simulation globale ;

- Le coût computationnel de chaque action possible ;

- L'historique des mises à jour précédemment déclenchées ;

- Une mesure d'écart entre les conditions limites de l'entrainement et de l'utilisation en simulation. En effet, il est important de vérifier que l'ensemble d'entrainement TS correspond effectivement aux entrées appliquées au réseau de neurones lors de son utilisation en prédiction. Si tel n'est pas le cas, l'étape S42 peut être déployée afin d'enrichir l'espace d'entrainement TS en fonction de l'utilisation effectivement.

Ainsi, la décision S3 peut se baser sur le coût du traitement informatique associé aux actions possibles.

Par exemple, une augmentation, S41, de l'ensemble d'apprentissage TS par interpolation est a priori moins coûteuse que la modification, S42, des paramètres du modèle physique de régénération de l'ensemble d'apprentissage TS. Aussi, lors qui l'évaluation S2 de la simulation S1 faire ressortir un manque de précision local, la décision peut être de préférer la première action à la seconde.

Ce choix peut ne pas reposer sur ce seul critère mais sur une heuristique multicritère dont le coût computationnel forme un des critères, éventuellement associé à une pondération.

Un autre critère peut être l'historique des mises à jour. Cet historique peut permettre d'éviter de déclencher un type de mise à jour qui a déjà été testé sans donner de résultats probants et/ou pour proposer une escalade dans les actions de mise à jour qui peuvent devenir pénalisante selon d'autres critères. Plus généralement, l'historique des valeurs paramétriques testés, associées à leur performance (résultat de la fonction de coût) forme un paysage dans lequel, itérativement, de nouveaux points peuvent être testés afin de chercher un optimum.

Ainsi, il est possible de proposer en première intention une première action peu coûteuse selon le coût computationnel, puis, si la même problématique se repose à une itération subséquente, de déclencher des actions plus coûteuses.

En reprenant l'exemple précédent, en cas de détection d'un manque local de précision, une augmentation, S41, de l'ensemble d'apprentissage TS par interpolation est prioritairement déclenchée, c'est-à-dire qu'elle peut d'abord être déclenché, puis, dans une itération subséquente, si le même problème se pose (sur la même zone), une modification, S42, des paramètres physiques du modèle physique de génération de l'ensemble d'apprentissage TS peut être déclenchée.

On peut ainsi améliorer la qualité du modèle prédictif. Cette amélioration peut se faire en parallèle de l'exploitation du modèle en simulation. C'est-à-dire que la boucle évaluation S2, décision S3, mise à jour S4 permet de déclencher un nouvel apprentissage qui permet de générer une nouvelle version du modèle prédictif. On peut considérer qu'un nouveau modèle prédictif est utilisé lorsqu'il aura suffisamment évolué. Un critère peut être mis en en place pour déclencher le remplacement d'un modèle par sa nouvelle version§.

Bien entendu, la présente invention n'est pas limitée aux exemples et au mode de réalisation décrits et représentés, mais elle est susceptible de nombreuses variantes accessibles à l'homme de l'art.

**Revendications**

1. Procédé de simulation du comportement d'un système (20) composé d'un sous-système (10) dans un environnement physique (21), par un ensemble de modules, chacun simulant une partie dudit système, dans lequel au moins une partie (11) dudit sous-système (10) est simulée par un module mettant en œuvre un réseau de neurones multicouches, les autres modules mettant en œuvre des simulations basées sur des lois physiques comportementales ; ledit procédé comprenant l'évaluation (S2) des résultats de la simulation pour automatiquement décider (S3) d'une stratégie pour déclencher des mises-à-jour (S4) de paramètres associés audit réseau de neurones multicouche.

2. Procédé selon la revendication précédente, dans lequel lesdites mises à jour (S4) comprennent une ou plusieurs actions parmi :

   - une augmentation (S41) d'un ensemble d'apprentissage (TS) par interpolation des données dudit ensemble et un réentrainement dudit réseau de neurones multicouche sur ledit ensemble d'apprentissage ;
   - une modification (S42) des paramètres physiques du modèle physique de génération de l'ensemble d'apprentissage (TS) et un réentrainement dudit réseau de neurones multicouche sur ledit ensemble d'apprentissage ;
   - une modification (S43) des méta-paramètres dudit réseau de neurones.

3. Procédé selon la revendication précédente, dans lequel lesdits méta-paramètres comprennent ceux déterminant l'architecture du réseau de neurones.

4. Procédé selon l'une des revendications précédentes, dans lequel ledit sous-système (10) est un véhicule aérien.

5. Procédé selon la revendication précédente, dans lequel ladite partie (11) est un turboréacteur.

6. Procédé selon l'une des revendications précédentes, dans lequel la décision (S3) d'une stratégie est basée sur un coût temporel associé à chacune desdites actions.

7. Procédé selon l'une des revendications précédentes, dans lequel la décision (S3) d'une stratégie est basée sur un historique des actions déjà déclenchées.

8. Procédé selon l'une des revendications précédentes dans lequel lorsque l'évaluation (S2) fait ressortir un manque local de précision de ladite simulation (S1), ladite augmentation (S41) est prioritairement déclenchée.

9. Procédé de conception d'un véhicule aérien comportant le procédé de simulation selon l'une des revendications précédentes.

10. Dispositif de simulation configuré pour la mise en œuvre du procédé selon l'une des revendications précédentes.

**Fig. 1**

**Fig. 2**

Fig. 3

Fig. 4

**Fig. 5**

Europäisches
Patentamt

European
Patent Office

Office européen
des brevets

**RAPPORT DE RECHERCHE EUROPEENNE**

Numéro de la demande

EP 21 17 4578

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | Luis Lopez Vega ET AL: "A Machine Learning Based Body Force Model for Analysis of Fan-Airframe Aerodynamic Interactions", 9 mai 2018 (2018-05-09), XP055767845, DOI: 10.5281/zenodo.1344526 Extrait de l'Internet: URL:https://core.ac.uk/download/pdf/163105275.pdf [extrait le 2021-01-22] * abrégé * * figure 2 * * page 1, section "Introduction": * * page 2, seconde colonne * * page 4, première colonne * * page 4, deuxième colonne, dernier paragraph * * page 6, première colonne, quatrième paragraphe * * le document en entier * ----- | 1-10 | INV. G06F30/15 G06F30/27 G06F30/28 |
| X | MAZHAR FARRUKH ET AL: "On using neural networks in UAV structural design for CFD data fitting and classification", AEROSPACE SCIENCE AND TECHNOLOGY, ELSEVIER MASSON, FR, vol. 30, no. 1, 29 août 2013 (2013-08-29), pages 210-225, XP028732579, ISSN: 1270-9638, DOI: 10.1016/J.AST.2013.08.005 * abrégé * * figures 1, 2, 9, 12, 18 * * sections 4-4.4 * * le document en entier * ----- -/-- | 1-10 | DOMAINES TECHNIQUES RECHERCHES (IPC) G06F |

Le présent rapport a été établi pour toutes les revendications

| Lieu de la recherche | Date d'achèvement de la recherche | Examinateur |
|---|---|---|
| Munich | 30 septembre 2021 | Joris, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

EP 21 17 4578

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | Anymous: "Training, validation, and test sets", Wikipedia, 17 avril 2020 (2020-04-17), XP055768092, Extrait de l'Internet: URL:https://en.wikipedia.org/w/index.php?title=Training,_validation,_and_test_sets&oldid=951517746 [extrait le 2021-01-22] * le document en entier *  ----- | 1-4,6,7, 10 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 30 septembre 2021 | Joris, Pierre |

EPO FORM 1503 03.82 (P04C02)

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
...................................................................
& : membre de la même famille, document correspondant

page 2 de 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A. ABBAS-BAYOUMI ; K. BECKER.** An industrial view on numerical simulation for aircraft aerodynamic design. *Journal of Mathematics in Industry,* 2011, vol. 1 (1), 10
- **DE LUIS LÓPEZ DE VEGA ; GUILLAUME DUFOUR ; FLORIAN BLANC ; WILLIAM THOLLET.** A Machine Learning Based Body Force Model for Analysis of Fan-Airframe Aerodynamic Interactions. *Global Power and Propulsion Society Conférence 2018,* 07 Mai 2018
- Three-Dimensional Flow in Turbomachine. **MARBLE, F. E.** High Speed Aerodynamics and Jet Propulsion. Princeton University Press, 1964, vol. 10, 83-166
- **HSIAO, E. ; NAIMI, M. ; LEWIS, J.P ; DALBEY, K. ; GONG, Y. ; TAN, C.** Actuator Duct Model for Turbomachinery Components for Powered-Nacelle Navier-Stokes Calculations. *Journal of Propulsion and Power,* Juillet 2001, vol. 17 (4
- **THOLLET, WILLIAM ; DUFOUR, GUILLAUME ; CARBONNEAU, XAVIER ; BLANC, FLORIAN.** Body-force modeling for aerodynamic analysis of air intake - fan interactions. *International Journal of Numerical Methods for Heat & Fluid Flow,* 2016, vol. 26 (7), ISSN 0961-5539, 2048-2065
- **LECUN, YANN A. et al.** Efficient backprop. Neural networks: Tricks of the trade. Springer Berlin Heidelberg, 2012, 9-48
- **DIEDERIK P. KINGMA ; JIMMY LEI BA.** *Adam: A method for stochastic optimization,* 2014
- **TIJMEN TIELEMAN ; GEOFFREY HINTON.** Lecture 6.5-rmsprop: Divide the gradient by a running average of its recent magnitude. *COURSERA: neural networks for machine learning,* 2012, vol. 4 (2), 26-31
- **DE RAISSI, MAZIAR ; PERDIKARIS, PARIS ; KARNIADAKIS, GEORGE E.** Physics-Informed Neural Networks: A Deep Learning Framework for Solving Forward and Inverse Problems Involving Nonlinear Partial Differential Equations. *Journal of Computational Physics,* 2019
- **EMMANUEL BENICHOU ; GUILLAUME DUFOUR ; YANNICK BOUSQUET ; NICOLAS BINDER ; AURÉLIE ORTOLAN ; XAVIER CARBONNEAU.** Body Force Modeling of the Aerodynamics of a Low-Speed Fan under Distorted Inflow. *Int. J. Turbomach. Propuls. Power,* 2019, vol. 4 (3), 29